# EUROPEAN PATENT SPECIFICATION

(11) **EP 0 276 717 B1**
(45) Date of publication and mention of the grant of the patent: **15.03.1995**
(21) Application number: 88100606.8
(22) Date of filing: 18.01.1988
(51) Int. Cl.: G03F 7/20, G03F 7/09

(54) **Method of forming a fine resist pattern in electron beam or x-ray lithography**
Verfahren zur Herstellung von feinsten Strukturen in Lacken durch Elektronen- oder Röntgenstrahllithographie
Procédé pour obtenir une couche de résine à motifs très fins par lithographie aux rayons x ou par faisceau d'électrons

(30) Priority: 27.01.1987 JP 16727/87
(43) Date of publication of application: 03.08.1988
(73) Proprietor: FUJITSU LIMITED, Kawasaki-shi, Kanagawa 211 (JP)
(72) Inventor: Kobayashi, Koichi c/o FUJITSU LIMITED Pat. Dept., Nakahara ku Kawasaki-shi Kanagawa 211 (JP); Takahashi, Yasushi c/o FUJITSU LIMITED Pat. Dept., Nakahara ku Kawasaki-shi Kanagawa 211 (JP)
(74) Representative: Greenstreet, Cyril Henry

(56) References cited:
- EP-A- 0 209 152
- DE-A- 2 927 242
- US-A- 4 298 803
- IBM TECHNICAL DISCLOSURE BULLETIN, vol. 24, no. 11A, April 1982, page 5549, New York, US; G.E. HENDERSON et al.: "Profile improvement in E-beam-exposed resist patterns"

## Description

This invention relates to a method of forming a fine resist pattern on a semiconductor substrate. More specifically, it relates to a lithography technique utilizing an electron beam or X-rays in an exposure process for a resist layer on the substrate.

The most common prior art lithography technique has utilised ultraviolet light to expose a resist layer formed on a semiconductor substrate. However, the ultraviolet light technique has resolution limitations and is not suitable for forming a resist pattern having dimensions of less than one micron. With a trend toward higher integration of semiconductor devices, the need to form patterns having down to submicron geometries has developed. This need has been partly filled by electron beams (EB) or X-ray lithography.

In electron beam lithography, an electron beam having an energy level of about 20 to 30 KeV (Kiloelectron-Volts) is applied to a resist layer having a thickness of about 1 micrometer formed on the semiconductor substrate. However, the electron beam still has enough energy even after it has penetrated through the resist layer for the electrons to collide with the substrate under the resist layer and further plunge thereinto. The plunging electrons lose their energy and forward and backward scattering of electrons occurs, so that the resist layer is subjected to extra exposure, especially by backwardly scattering electrons. Because the scattering directions of the electrons are isotropic, the adjacent portion to the pattern edge of the resist layer is influenced by the scattering electrons, even though this portion is not directly exposed to the primary electron beam. The indirect exposure to the scattering electrons causes deterioration of pattern precision or, in other words, deterioration of contrast or blurring of the pattern, similar to "out of focus" in photography.

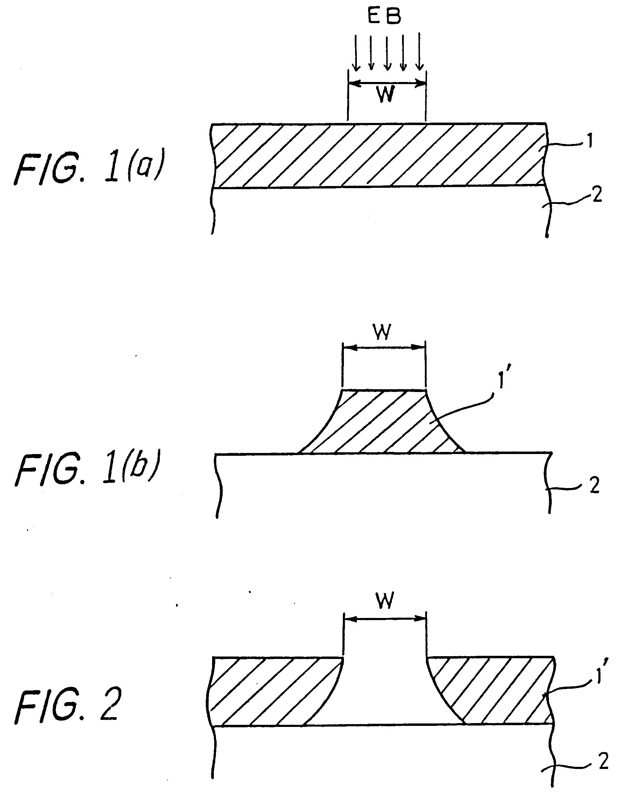

Figs. 1(a) and 1(b) illustrate a cross-section showing how a negative type resist layer 1 formed on a semiconductor substrate 2 is exposed to an electron beam EB in a region having a width W and is developed. Hereinafter, a negative type electron beam resist will be referred to for brevity as a negative EB resist. After the resist layer 1 is developed, a pattern 1′ is obtained, which has a precise dimension W on the surface of the patterned resist layer and a width almost equal to the dimension of the pattern swept by the electron beam, but has a gradually and outwardly extending profile towards the surface of the substrate 2 due to the scattering electrons. When a positive EB resist layer 1 is used, the resist pattern 1′ formed is reversed as shown in Fig. 2.

In X-ray lithography, the X-rays collide with the substrate after penetrating through the resist layer, generating the emission of electrons (photons) from the substrate surface. Similarly the resist layer is exposed to the scattering photons, resulting in decrease of contrast or blurring of resist pattern as shown in Fig. 1(b) and Fig. 2, as explained for EB lithography. These phenomena are especially pronounced when SOR (Synchrotron Orbitary Radiation) is used as an X-ray source, particularly when a very short wavelength such as less than one Angstrom (0.1 nm) is utilised.

Several methods have been developed in the prior art to solve the above problem. One method is to control the accelerating voltage of the electron beam. When the electron beam accelerating voltage is increased, the electron penetrates more deeply into the substrate, and the backward scattering electrons from such a deep portion in the substrate have less energy and the effects on the resist layer are alleviated. The use of an electron beam of higher voltage is therefore preferable in order to obtain reduced pattern blurring.

Another method is to apply a multilayer resist system, wherein a plurality of resist layers are coated and laminated on the substrate, the upper resist layer being used as a sensitive layer to the electron beam and the lower resist layer having a comparatively larger thickness than that of the upper layer and being used as a buffer or absorbing layer for scattering electrons.

The above methods are common technology for both EB and X-ray lithography. There are still other methods of improvement, but it is always a problem to improve the resolution avoiding blurring in EB or X-ray lithography.

DE-A-29 27 242, IBM Technical Disclosure Bulletin, Vol. 24, No. 11A, April 1982, page 5549, EP-A-0 209 152 and US-A-4 298 803 disclose two-step exposure processes in which an electron beam or X-ray resist material is pre-exposed or post-exposed to blanket UV light.

According to the present invention there is provided a method of forming a resist pattern on a substrate, wherein a resist layer is provided on the substrate and is subjected to at least two exposure steps including an electron beam/X-ray exposure step and an untraviolet radiation exposure step, the method being characterised in that
the resist layer is provided by coating on the substrate a mixed solution of (a) electron beam/X-ray sensitive resist material and (b) ultraviolet radiation absorbing material,
and in that
the resist layer is selectively exposed to electron beam/X-rays with a total irradiation density less than that which would cause the entire thickness of the resist layer to undergo chemical reaction, and such that backward scattered electrons thereby produced do not cause chemical reaction in resist regions outside the region of selective exposure, and
the entire surface of the resist layer is exposed to ultraviolet radiation for a period shorter than the minimum duration which would be necessary for inducing a reaction of the resist layer if it were exposed solely to the ultraviolet radiation, but sufficient in combination with the electron beam/X-ray exposure for the entire thickness of the region of selective exposure to undergo chemical reaction.

An embodiment of the invention provides a method of forming a resist pattern in which deterioration of resolution due to the backward scattering electrons or photons in the EB or X-ray lithography is avoided.

An embodiment of the invention also provides such a method which can be employed in the conventional apparatus used in EB or X-ray lithography and which consists of simple process steps.

In an embodiment of the invention: (1) an EB or X-ray resist material which is mixed with ultraviolet radiation absorbing material is utilised; (2) the resist layer is selectively exposed to an EB or X-rays having an energy level below that used in the conventional EB or X-ray exposure for obtaining chemical reaction of the resist layer; and (3) the entire surface of the resist layer is further exposed to ultraviolet radiation having an energy level below the minimum quantity of irradiation necessary for the resist layer to show photo reaction.

The selectively exposed region of the resist layer receives both exposures of ultraviolet-radiation (abbreviated as UV radiation) and EB or X-rays enough for the resist material to show a chemical reaction such as a crosslinking reaction. However, in the region outside the selective exposure region a substantial part of the UV radiation is absorbed in the upper portion of the resist layer, especially near the surface thereof, and very little of the UV radiation can reach the boundary surface with the semiconductor substrate. The resist layer not exposed to the EB or X-rays does not receive enough energy to show the chemical reaction, even though it is subjected to a lot of backward scattering electrons. As a result, contrast or resolution is remarkably improved and the blurring phenomena of the resist pattern can be avoided.

The above method of the present invention is not restricted to a particular order of the UV radiation and EB/X-ray exposures. The UV radiation exposure can be applied before or after EB/X-ray exposure, and the same result can be achieved.

Embodiments of the invention will now be described in more detail with reference to the accompanying drawings, in which:
Figs. 1(a) and 1(b) are cross-sections illustrating a prior art method in which a negative type resist layer is formed on substrate and is exposed to an EB over a region having a width W and is then developed;
Fig. 2 is a cross-section illustrating a prior art method in which a positive EB resist layer is formed, exposed and developed instead of the negative EB resist layer used in Fig. 1, resulting in the formation of a reversed pattern from that shown in Fig. 1(b);
Fig. 3 shows a typical relation between the thickness of the residual resist layer after development and the total electron charge density applied during the EB exposure, using the resist material of the present invention;
Fig. 4 also shows a typical relation between the thickness of the residual resist layer after development and the exposure period by a conventional UV radiation source, using the same resist material as that of Fig. 3; and
Fig. 5 shows a schematic cross-section of three resist patterns, of which pattern sample 1 is formed utilising the method of the present invention, and pattern samples 2 and 3 are formed utilising the resist material of the prior art, as described below.

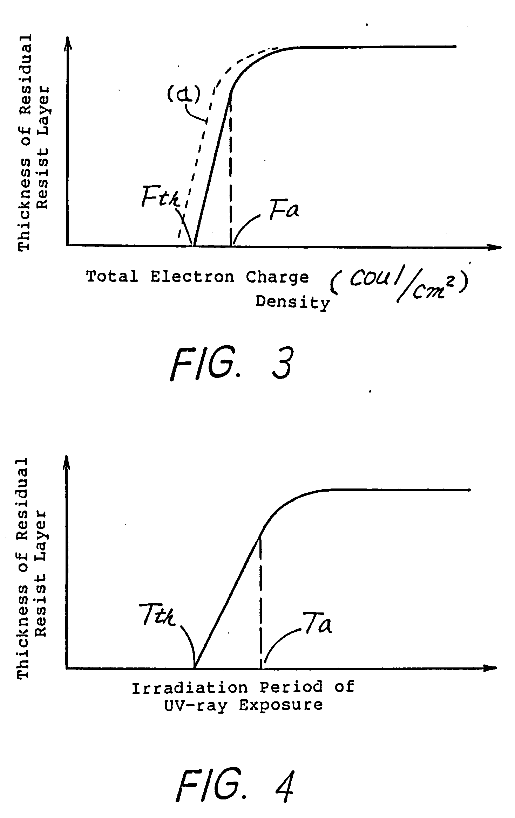

Fig. 3 shows a relation between the thickness of the residual resist layer and the total electron charge density applied during the EB exposure, when the resist layer is formed utilising a negative EB resist material mixed with an UV radiation absorbing material and is exposed to an EB and then developed. Fig. 3 shows a typical curve for the purpose of illustrating generally the characteristics of the negative resist material of the present invention. As can be seen from Fig. 3, a total charge density greater than Fth is necessary for at least part of the resist layer to remain after the exposure and development steps, or, in other words, for the resist material partly to show the chemical reaction. In practice, a total charge density Fa is used.

The resist material described shows a similar reaction characteristic when exposed to UV radiation. Fig. 4 shows a typical curve of the measured data. In this Figure, the abscissa shows the irradiation period during exposure using a conventional UV radiation source. The curve shows a similar tendency to that shown in Fig. 3; however in Fig. 4, Tth denotes the minimum duration for the resist layer to remain at least in part after the development. In order to obtain the conventional thickness of resist layer, the duration Ta is necessary for the exposure process using the UV radiation alone.

In the EB exposure process, the value of Fth is little affected by changing the accelerating voltage. When the accelerating voltage is increased, the curve is shifted to the left as shown by the dashed curve (a) in Fig. 3. In carrying out the present invention, the total charge density of EB irradiation onto the exposure area, using a constant accelerating voltage E KEV, is controlled in such a way that the quantity of backward scattering electrons to the nearby portion of the resist layer outside the exposure area is reduced to a level less than Fth. In this case, in other words, the total charge density on to the exposed area usually becomes less than Fa, and there is therefore not enough charge density for the entire thickness of the resist layer to undergo sufficient chemical reaction for the resist to remain after development.

In the present invention, this shortage of electron charge is supplemented by application of the UV radiation on to the entire surface of the resist layer without a mask. The duration of irradiation in the supplementary UV radiation exposure is shorter than Tth which is shown in Fig. 4. Therefore the resist layer, which has not been subjected to the previous EB described above or is not subsequently given another exposure, does not show any reaction in lithography processes.

In the case of X-ray exposure, the X-ray resist has similar characteristics to those described with regard to the EB resist, and therefor a similar curve to that shown in Fig. 3 can be obtained except that the abscissa is replaced by the total X-ray irradiation density. The exposure processes are almost the same as those explained above except that the EB exposure is replaced by the X-ray exposure.

### (1) Embodiment 1

Chloromethylated polystyrene (abbreviated as CMS) was used as the negative EB resist, and p-azido acetophenone was used as the UV-ray absorbing material. A xylene solution containing 20 to 30 weight percent of CMS and 10 weight percent of p-azido acetophenone was used for coating the resist material. The resist material was coated on the substrate with a thickness of 1.2 »m by a spin-coating method and dried for 20 minutes at 80.C.

The substrate was then subjected to deep UV radiation exposure from a 500 watt Xe-Hg lamp using an exposure apparatus model PLA-500F made by CANON. The entire surface of the resist layer was exposed to the UV radiation without a mask, and the period of exposure was chosen to be 0.5 to 1 second, corresponding to a value lower than Tth in Fig. 4, and the exposure was controlled by an aluminium mirror. Thereafter, the resist layer was selectively exposed to a 20 KeV electron beam by sweeping the EB, thereby forming the pattern. The total charge density of the EB was maintained as about 2 × 10⁻⁵ coul/cm². For convenience, the pattern obtained by this method, after development, is called pattern sample 1.

For the purpose of comparison, a resist solution containing only CMS, the material generally used in the prior art, was provided and coated on the substrate in the same way. As a first comparison test, the substrate was subjected to the EB exposure only, the total charge density being maintained at 3 x 10⁻⁵ coul/cm² using the same accelerating voltage as for pattern sample 1. This sample after development is called pattern sample 2.

Next, using the same resist solution of CMS, the resist layer was coated on another substrate. This substrate was exposed first to the deep UV radiation and thereafter to the EB exposure under the same conditions as those used for pattern sample 1. This pattern sample after development is called pattern sample 3.

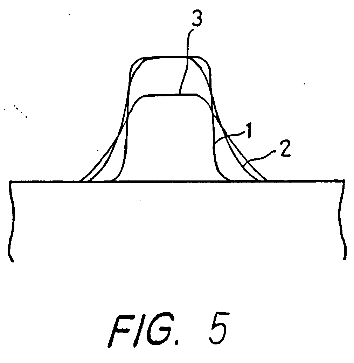

Cross-sections of the above three pattern samples are shown schematically in Fig. 5. Pattern samples 2 and 3 have lower slopes extending outwardly, and the width W thereof on the substrate surface is increased by about 0.3 »m: this deformation causes reduction of contrast or blurring of formed patterns in lithography. Moreover the thickness of pattern sample 3 is reduced to 0.7 »m, in contrast to a normal thickness of greater than 1.0 »m of pattern samples 1 and 2. This shows that in pattern sample 3 the total energy of the UV radiation and EB exposures is insufficient.

Comparing the three methods of forming resist patterns, the method applied for pattern sample 1, in which the new resist material and the exposure method according to the present invention are used, shows the most satisfactory shape for obtaining high resolution.

### (2) Embodiment 2

As the UV radiation absorbing material, p-azido benzoic acid was used mixed with chloromethylated polystyrene (CMS). A solution of these materials was utilised in resist coating, and the resist layer formed on the substrate was processed and exposed under the same conditions as in Embodiment 1. After comparison tests, almost the same results were obtained as pattern sample 1 in Embodiment 1. This shows that CMS resist material mixed with p-azido benzoic acid as the UV radiation absorbing material is effective in obtaining high resolution.

### (3) Embodiment 3

In the same way as Embodiment 2, CMS resist material mixed with 3-sulfonylazido benzoic acid was utilised, instead of p-azido benzoic acid in Embodiment 2. The same comparison tests were performed using this resist material. Test results shown that 3-sulfonylazido benzoic acid is also effective as the UV radiation absorbing material mixed with the CMS resist.

### (4) Embodiment 4

As the negative EB resist material, polydiarylorthophthalate (abbreviated as PDOP) was used. P-azido acetophenone was used as the UV radiation absorbing material mixed with PDOP. A solution of these materials was utilised as the coating material for forming the resist layer. The same tests as applied in the above Embodiments were carried out, and as a result, it was found that p-azido acetophenone mixed with PDOP is also an effective resist material for obtaining high resolution.

### (5) Embodiment 5

As the positive EB resist, polymethyl methacrylate (abbreviated as PMMA) was used. P-azido acetophenone, as the UV radiation absorbing material, was mixed with PMMA and this combination of these two materials proved to be effective for obtaining high resolution.

### (6) Embodiment 6

In this embodiment, tests were performed using the same resist material and the same exposure conditions as those utilised in obtaining pattern sample 1 in Embodiment 1 except that the substrate was inclined to the incident UV radiation at an angle of 30 to 70 degrees. The increase in the pattern width W was further reduced, resulting in further improvement in resolution. This tilting of the substrate during exposure is effective even in the case of obtaining pattern samples 2 or 3, in which resist material of the prior art is utilised, comprising no UV radiation absorbing material.

### (7) Embodiment 7

Further tests were performed employing X-rays instead of an EB, using the same resist material used in the above Embodiments. The X-rays were irradiated on to the resist layer through an X-ray mask. As an X-ray source, an electron beam excited (20 KeV accelerating voltage) source for generating Al-K alpha radiation was utilised. Although an electron beam excited X-ray source was used in this Embodiment, SOR can also be utilised as another X-ray source. The irradiation energy on to the resist layer was 500 mJ/cm². Conditions for the UV radiation exposure were the same as those applied in Embodiment 1. Very similar results were obtained in improving the resolution.

### (8) Embodiment 8

When UV radiation longer than 280 nm in wavelength is filtered out in the UV radiation exposure process in Embodiment 1, the increase of pattern width is further reduced, resulting in improvement of contrast and resolution.

The resist material such as CMS, PDOP or PMMA used in the above Embodiments has sensitivity in the deep UV wavelength region of shorter than 300 nm. Therefore, material such as p-azido acetophenone, p-azido benzoic acid, or 3-sulfonylazido benzoic acid, each having a large absorption coefficient in the 200 to 300 nm wavelength region, was utilised as UV radiation absorbing material mixed with the above described resist materials.

When the EB or X-ray resist material having sensitivity near 365 nm or 436 nm wavelength, for example, OMR-83 or OFPR of TOKYO OUKA KOGYO manufacture, is used, a UV radiation exposure having a peak energy distribution around the above wavelength is very effective and good results can be obtained.

In all the Embodiments disclosed above, the EB or X-ray exposure is performed after the exposure of UV radiation on to the entire substrate surface. However, the order of exposure can be reversed so that the resist layer is first exposed selectively to the EB or X-rays and is subsequently exposed to the UV radiation on its entire surface. It has been confirmed that the same results can be obtained in respect of improvements in resolution.

The present invention may be embodied in other specific forms without departing from the spirit or essential characteristics thereof. The presently disclosed embodiments are therefore to be considered in all respects as illustrative and not restrictive, the scope of the invention being indicated by the appended claims, rather than the foregoing description, and all changes which come within the scope of the claims are, therefore, to be embraced therein.

## Claims

1. A method of forming a resist pattern on a substrate, wherein a resist layer is provided on the substrate and is subjected to at least two exposure steps including an electron beam/X-ray exposure step and an untraviolet radiation exposure step, the method being characterised in that
the resist layer is provided by coating on the substrate a mixed solution of (a) electron beam/X-ray sensitive resist material and (b) ultraviolet radiation absorbing material,
and in that
the resist layer is selectively exposed to electron beam/X-rays with a total irradiation density less than that which would cause the entire thickness of the resist layer to undergo chemical reaction, and such that backward scattered electrons thereby produced do not cause chemical reaction in resist regions outside the region of selective exposure, and
the entire surface of the resist layer is exposed to ultraviolet radiation for a period shorter than the minimum duration which would be necessary for inducing a reaction of the resist layer if it were exposed solely to the ultraviolet radiation, but sufficient in combination with the electron beam/X-ray exposure for the entire thickness of the region of selective exposure to undergo chemical reaction.

2. A method of forming a resist pattern on a substrate according to claim 1, wherein said resist layer is first exposed to electron-beam/X-rays and subsequently exposed to ultraviolet radiation.

3. A method of forming a resist pattern on a substrate according to claim 1, wherein said resist layer is first exposed to ultraviolet radiation and subsequently exposed to electron-beam/X-rays.

4. A method of forming a resist pattern on a substrate according to any preceding claim, wherein p-azido acetophenone is used as said ultraviolet radiation absorbing material and chloromethylated polystyrene (CMS) is used as said resist material.

5. A method of forming a resist pattern on a substrate according to any one of claims 1 to 3, wherein p-azido benzoic acid is used as said ultraviolet radiation absorbing material and chloromethylated polystyrene (CMS) is used as said resist material.

6. A method of forming a resist pattern on a substrate according to any one of claims 1 to 3, wherein 3-sulfonylazido benzoic acid is used as said ultraviolet radiation absorbing material and chloromethylated polystyrene (CMS) is used as said resist material.

7. A method of forming a resist pattern on a substrate according to any one of claims 1 to 3, wherein p-azido acetophenone is used as said ultraviolet radiation absorbing material and polydiarylorthophthalate (PDOP) is used as said resist material.

8. A method of forming a resist pattern on a substrate according to any one of claims 1 to 3, wherein p-azido acetophenone is used as said ultraviolet radiation absorbing material and polymethyl methacrylate (PMMA) is used as said resist material.

9. A method of forming a resist pattern on a substrate according to any preceding claim, wherein the substrate is inclined to the incident ultraviolet radiation during said step of exposure to ultraviolet radiation.

10. A method of forming a resist pattern on a substrate according to any one of claims 4 to 9, wherein the ultraviolet radiation used in said exposure step is filtered to exclude ultraviolet radiation longer than 280 nm in wavelength.

## Patentansprüche

1. Verfahren zur Bildung eines Resistmusters auf einem Substrat, bei dem eine Resistschicht auf dem Substrat vorgesehen wird und wenigstens zwei Belichtungsschritten unterzogen wird, einschließlich eines Elektronenstrahl-/Röntgenstrahlbelichtungsschrittes und eines Belichtungsschrittes mit ultravioletter Strahlung, welches Verfahren dadurch gekennzeichnet ist, daß
die Resistschicht durch Auftragen einer gemischten Lösung von (a) elektronenstrahl-/röntgenstrahlempfindlichem Resistmaterial und. (b) ultraviolette Strahlung absorbierendem Material auf dem Substrat vorgesehen wird, und daß
die Resistschicht selektiv mit Elektronenstrahlen/Röntgenstrahlen mit einer Gesamtbestrahlungsdichte belichtet wird, die geringer ist als diejenige, die eine chemische Reaktion der gesamten Dicke der Resistschicht verursachen würde, und in der Weise, daß dadurch erzeugte rückwärtsgestreute Elektronen keine chemische Reaktion in Resistbereichen außerhalb des Bereiches der selektiven Belichtung verursachen, und
die gesamte Oberfläche der Resistschicht mit ultravioletter Strahlung für einen Zeitraum belichtet wird, der kürzer ist als die Mindestdauer, die erforderlich wäre, um eine Reaktion der Resistschicht zu induzieren, wenn sie allein mit ultravioletter Strahlung belichtet würde, jedoch in Kombination mit der Elektronenstrahl-/Röntgenstrahlbelichtung für die gesamte Dicke des Bereiches der selektiven Belichtung ausreichend ist, um diese einer chemischen Reaktion zu unterziehen.

2. Verfahren zur Bildung eines Resistmusters auf einem Substrat nach Anspruch 1, bei dem die Resistschicht zunächst mit Elektronenstrahlen/Röntgenstrahlen belichtet wird und anschließend mit ultravioletter Strahlung belichtet wird.

3. Verfahren zur Bildung eines Resistmusters auf einem Substrat nach Anspruch 1, bei dem die Resistschicht zunächst mit ultravioletter Strahlung belichtet wird und anschließend mit Elektronenstrahlen/Röntgenstrahlen belichtet wird.

4. Verfahren zur Bildung eines Resistmusters auf einem Substrat nach einem der vorstehenden Ansprüche, bei dem p-Azidoacetophenon als das ultraviolette Strahlung absorbierende Material und chlormethyliertes Polystyrol (CMS) als das Resistmaterial verwendet wird.

5. Verfahren zur Bildung eines Resistmusters auf einem Substrat nach einem der Ansprüche 1 bis 3, bei dem p-Azidobenzoesäure als das ultraviolette Strahlung absorbierende Material verwendet wird und chlormethyliertes Polystyrol (CMS) als das Resistmaterial verwendet wird.

6. Verfahren zur Bildung eines Resistmusters auf einem Substrat nach einem der Ansprüche 1 bis 3, bei dem 3-Sulfonylazidobenzoesäure als das ultraviolette Strahlung absorbierende Material verwendet wird und chlormethyliertes Polystyrol (CMS) als das Resistmaterial verwendet wird.

7. Verfahren zur Bildung eines Resistmusters auf einem Substrat nach einem der Ansprüche 1 bis 3, bei dem p-Azidoacetophenon als das ultraviolette Strahlung absorbierende Material und Polydiarylorthophthalat (PDOP) als das Resistmaterial verwendet wird.

8. Verfahren zur Bildung eines Resistmusters auf einem Substrat nach einem der Ansprüche 1 bis 3, bei dem p-Azidoacetophenon als das ultraviolette Strahlung absorbierende Material verwendet wird und Polymethylmethacrylat (PMMA) als das Resistmaterial verwendet wird.

9. Verfahren zur Bildung eines Resistmusters auf einem Substrat nach einem der vorstehenden Ansprüche, bei dem das Substrat gegen die einfallende ultraviolette Strahlung während des Belichtungsschrittes mit ultravioletter Strahlung geneigt wird.

10. Verfahren zur Bildung eines Resistmusters auf einem Substrat nach einem der Ansprüche 4 bis 9, bei dem die in diesem Belichtungsschritt verwendete ultraviolette Strahlung gefiltert wird, um ultraviolette Strahlung mit einer längeren Wellenlänge als 280 nm auszuschließen.

## Revendications

1. Procédé de formation d'un motif de réserve sur un substrat, dans lequel une couche de réserve est déposée sur le substrat et est soumise à au moins deux étapes d'exposition incluant une étape d'exposition à un faisceau électronique/à des rayons X et une étape d'exposition à un rayonnement ultraviolet, le procédé étant caractérisé en ce que :
la couche de réserve est constituée en déposant sur le substrat une solution mixte (a) d'un matériau de réserve sensible au faisceau électronique/rayons X et (b) d'un matériau d'absorption du rayonnement ultraviolet ; et
en ce que la couche de réserve est exposée sélectivement au faisceau électronique/rayons X moyennant une densité d'irradiation totale inférieure à celle qui ferait que l'épaisseur totale de la couche de réserve subirait une réaction chimique et qui est telle que des électrons diffusés vers l'arrière ainsi produits ne provoquent pas une réaction chimique dans des régions de réserve externes à la région d'exposition sélective ; et
la totalité de la surface de la couche de réserve est exposée à un rayonnement ultraviolet pendant une période inférieure à la durée minimum qui serait nécessaire pour induire une réaction de la couche de réserve si elle était exposée seulement au rayonnement ultraviolet mais qui est suffisante en combinaison avec l'exposition à un faisceau électronique/rayons X pour que la totalité de l'épaisseur de la région d'exposition sélective subisse une réaction chimique.

2. Procédé de formation d'un motif de réserve sur un substrat selon la revendication 1, dans lequel ladite couche de réserve est tout d'abord exposée à un faisceau électronique/rayons X puis est ensuite exposée à un rayonnement ultraviolet.

3. Procédé de formation d'un motif de réserve sur un substrat selon la revendication 1, dans lequel ladite couche de réserve est tout d'abord exposée à un rayonnement ultraviolet puis est ensuite exposée à un faisceau électronique/rayons X.

4. Procédé de formation d'un motif de réserve sur un substrat selon l'une quelconque des revendications précédentes, dans lequel un p-azido acétophénone est utilisé en tant que dit matériau absorbeur de rayonnement ultraviolet et un polystyrène chlorométhylaté (CMS) est utilisé en tant que dit matériau de réserve .

5. Procédé de formation d'un motif de réserve sur un substrat selon l'une quelconque des revendications 1 à 3, dans lequel un acide p-azido benzoïque est utilisé en tant que dit matériau absorbeur de rayonnement ultraviolet et un polystyrène chlorométhylaté (CMS) est utilisé en tant que dit matériau de réserve.

6. Procédé de formation d'un motif de réserve sur un substrat selon l'une quelconque des revendications 1 à 3, dans lequel un acide 3-sulfonylazido benzoïque est utilisé en tant que dit matériau absorbeur de rayonnement ultraviolet et un polystyrène chlorométhylaté (CMS) est utilisé en tant que dit matériau de réserve.

7. Procédé de formation d'un motif de réserve sur un substrat selon l'une quelconque des revendications 1 à 3, dans lequel un p-azido acétophénone est utilisé en tant que dit matériau absorbeur de rayonnement ultraviolet et un polydiarylorthophthalate (PDOP) est utilisé en tant que dit matériau de réserve.

8. Procédé de formation d'un motif de réserve sur un substrat selon l'une quelconque des revendications 1 à 3, dans lequel un p-azido acétophénone est utilisé en tant que dit matériau absorbeur de rayonnement ultraviolet et un méthacrylate de polyméthyle (PMMA) est utilisé en tant que dit matériau de réserve.

9. Procédé de formation d'un motif de réserve sur un substrat selon l'une quelconque des revendications précédentes, dans lequel le substrat est incliné par rapport au rayonnement ultraviolet incident pendant ladite étape d'exposition à un rayonnement ultraviolet.

10. Procédé de formation d'un motif de réserve sur un substrat selon l'une quelconque des revendications 4 à 9, dans lequel le rayonnement ultraviolet utilisé lors de ladite étape d'exposition est filtré afin d'exclure un rayonnement ultraviolet d'une longueur d'onde supérieure à 280 nm.
